(19) Europäisches Patentamt

European Patent Office

Office européen des brevets

(11) **EP 0 905 884 B1**

(12) **EUROPÄISCHE PATENTSCHRIFT**

(45) Veröffentlichungstag und Bekanntmachung des Hinweises auf die Patenterteilung:
**18.02.2004 Patentblatt 2004/08**

(51) Int Cl.⁷: **H03G 3/30**

(21) Anmeldenummer: **98117336.2**

(22) Anmeldetag: **12.09.1998**

(54) **Sender zum Erzeugen eines hochfrequenten Sendesignals**

Radio frequency transmitter

Emetteur radiofréquence

(84) Benannte Vertragsstaaten:
**DE FI FR GB SE**

(30) Priorität: **30.09.1997 DE 19743274**

(43) Veröffentlichungstag der Anmeldung:
**31.03.1999 Patentblatt 1999/13**

(73) Patentinhaber: **Infineon Technologies AG**
**81669 München (DE)**

(72) Erfinder:
• **Feng, Shen**
**81373 München (DE)**

• **Herzinger, Stefan**
**80686 München (DE)**

(74) Vertreter: **Epping Hermann & Fischer**
**Ridlerstrasse 55**
**80339 München (DE)**

(56) Entgegenhaltungen:
WO-A-95/16304          US-A- 4 952 889
US-A- 5 130 676          US-A- 5 313 173

**Beschreibung**

Die Erfindung betrifft einen Sender zum Erzeugen eines hochfrequenten Sendesignals, welcher beispielsweise in Mobilfunksystemen eingesetzt werden kann. Diese können unter anderem den weit verbreiteten GSM-Standard (Global System For Mobil Communication) oder den DCS1900-Standard benutzen. Die Erfindung ist jedoch nicht auf die explizit genannten Standards beschränkt, sondern kann für alle Kommunikationssysteme verwendet werden, bei denen die Modulation des Datensignals derart erfolgt, daß dessen Amplitude beibehalten wird.

Das GSM-Netz besteht, wie jedes andere Telekommunikationsnetz auch, aus Systembestandteilen, die Schnittstellen bedienen und Funktionalitäten bereitstellen. Es arbeitet in den Frequenzbereichen 890 MHz bis 950 MHz und 935 MHz bis 960 MHz. Das Netz ist aus einer Vielzahl von Funkstellen aufgebaut. Die Anzahl der modular einsetzbaren Grundbausteine im GSM-Netz ist jedoch verhältnismäßig gering. Das Base-Station-Sub-System (Basisstationsteilsystem) organisiert den sicheren Datenaustausch zwischen den Mobilstationen und der Netzinfrastruktur. Dazu gehören Aufbau, Aufrechterhaltung und Aufbau der Funkverbindung zwischen Mobilstationen und der Base-Tranceiver-Station (Basisstation). Darüber hinaus wird eine ständige Qualitätsbeurteilung des Funkkanals und die daraus abzuleitenden Reaktionen des Systems z.B. die Einleitung und Steuerung von Zellwechseln (Hand-Over) vorgenommen. Außerdem werden Informationen über den Aufenthaltsort der Mobilstationen an das Netz weitergegeben. Das vermittlungstechnische Teilsystem (Switching-Subsystem) führt zum einen alle Aufgaben aus, die zum Aufbau, Verwalten und Lösen von Verbindungen benötigt werden. Zum anderen muß das vermittlungstechnische Teilsystem aber auch alle mobilitätsbedingten Verfahren durchführen. Dies reicht von der Verwaltung der statischen Teilnehmerdaten über das Auffinden einer gerufenen Mobilstation an einem beliebigen Ort des GSM-Versorgungsbereichs bis zur zuverlässigen Erfassung aller Gebührendaten. Daneben bedient das vermittlungstechnische Teilsystem Schnittstellen zu anderen Telekommunikationsnetzen oder Telekommunikationsdiensten.

Die Funkstrecke zwischen dem Mobilteil und der Netzinfrastruktur ist von zwei Grundeigenschaften geprägt: Die Ressource Funkkanal ist nur eingeschränkt verfügbar. Sie kann prinzipiell an einem Ort zur selben Zeit nur einmal verwendet werden. Jeder Funkkanal ist hochgradig störanfällig. Das Auftreten von Störungen in diesen offenen Systemen kann nicht unterbunden werden. Auf einem physikalischen Funkkanal werden zeitgeteilt acht physikalische Nachrichtenkanäle, genannt Bursts, übertragen. Eine vollständige Sequenz aller acht Kanäle wird TDMA-Rahmen (Time-Division-Multible-Access) genannt. Auf jedem physikalischen Nachrichtenkanal können Signalisierungs- und/oder Nutzinformationen auf sogenannten logischen Kanälen vermittelt werden. Die Zuordnung von logischen auf physikalische Kanäle wird als Mapping bezeichnet. Das Mapping ist dynamisch und wechselt in Abhängigkeit von Betriebszustand und zu realisierender Übertragungsaufgabe, z.B. bei der Übertragung von Sprachinformationen über den Normalburst bei bestehender Telefonverbindung. Die logischen Kanäle bestehen aus den Verkehrskanälen und den Steuer- oder Kontrollkanälen.

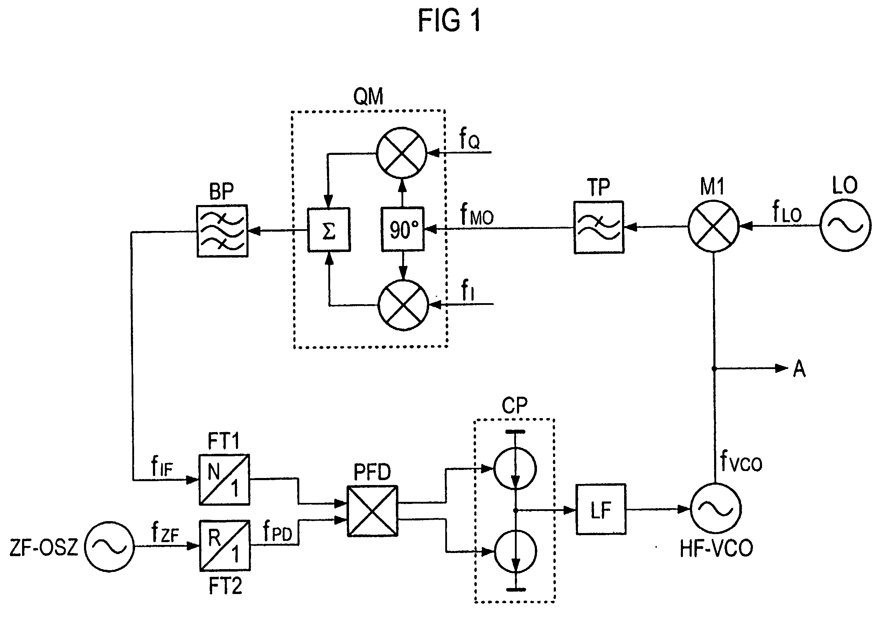

Um das Signal über die Luftschnittstelle zu übertragen, ist ein Sender notwendig, der das Datensignal im Basisband so aufbereitet, daß es über die Luftschnittstelle übertragbar ist. Dabei dürfen keine Konflikte mit anderen zu übertragenden Informationen, die von anderen Funksystemen stammen, entstehen. Eine Voraussetzung für eine gute Sendesignalqualität ist ein niedriger Rauschpegel weitab vom Träger bei hoher Sendeleistung. Dazu ist aus dem Stand der Technik ein in Figur 1 gezeigter Sender bekannt. Dieser weist einen lokalen Oszillator LO, der zur Kanaleinstellung dient, auf. Das vom lokalen Oszillator LO stammende Signal mit der Frequenz fLO wird mit einem Sendesignal der Frequenz fVCO, welches von einem Hochfrequenzoszillator HF-VCO stammt mittels eines Mischers M1 gemischt und einem Tiefpaß TP zugeführt. Das am Ausgang des Tiefpasses TP anliegende Modulatoreingangssignal mit der Frequenz fMO wird auf einen Quadraturmodulator QM geführt, der das Inphase-Datensignal mit der Frequenz fI und das Quadratur-Datensignal mit der Frequenz fQ jeweils mit dem Modulatoreingangssignal (Frequenz fMO) mischt und die entsprechenden Mischerausgangssignale addiert. Das so gewonnene quadraturmodulierte Signal wird durch den Bandpaß BP gefiltert und einem ersten Frequenzteiler FT1 mit dem Teilerverhältnis N zugeführt. Der erste Frequenzteiler FT1 teilt das Signal mit der Frequenz fIF durch den Teilerwert N und führt das geteilte Signal auf einen Phasenfrequenzvergleicher PFD. Das von einem Zwischenfrequenzoszillator ZF-OSZ stammende Signal mit der Frequenz fZF wird einem zweiten Frequenzteiler FT2 mit dem Teilerwert R zugeführt, welcher die Frequenz fZF durch den Teilerwert R teilt und dem Phasenfrequenzvergleicher PFD zuführt. Dieser vergleicht anfänglich die an dessen Eingängen anliegenden Frequenzen und später deren Phasen miteinander. Der Phasenfrequenzvergleicher PFD erzeugt entsprechende Steuerausgangssignale, üblicherweise in Form von Nadelimpulsen, welche einer Ladungspumpe CP zugeführt werden. Die Ladungspumpe CP in Verbindung mit einem passiven Schleifenfilter LF wirkt wie ein aktives Schleifenfilter. Das am Ausgang des Schleifenfilters LF anliegende Signal steuert den Hochfrequenzoszillator HF-VCO, welcher dann direkt das Sendesignal mit der Frequenz fVCO erzeugt, das am Ausgang A des Senders abgreifbar ist.

Die beschriebene Schaltung hat gravierende Nachteile. Erstens weist das vom Mischer M1 erzeugte Signal einen hohen Störsignalanteil auf, weil sowohl der Hochfrequenzoszillator HF-VCO, als auch der Lokaloszillator LO einen nicht unerheblichen Klirrfaktor aufweisen, d.h. sie erzeugen Signale mit einer Grundfrequenz und mehreren Harmonischen dazu. Zusätzlich wird beim Wechseln der Frequenz fLO von einer ersten auf eine zweite Kanalfrequenz ein gegenüber dem ersten Mischprodukt verschiedenes Mischprodukt entstehen, was bedeutet, daß am Mischerausgang neue, veränderte Störsignalanteile auftreten. Die Frequenzen der Störsignalanteile können zudem sehr nahe bei der Sendefrequenz fVCO liegen. Zweitens können Störungen vom Phasenfrequenzvergleicher PFD ausgehen, wobei diese frequenzmäßig ebenfalls in der Näher der Sendefrequenz fVCO liegen können.

Aus dem Dokumenten US-A-5 313 173 und WO 95/16304 sind Quadraturmodulatoren mit VCOs für Sender bekannt.

Eine Aufgabe der Erfindung ist es, einen Sender anzugeben, bei dem die im Stand der Technik auftretenden Störungen vermieden werden.

Die Aufgabe wird durch einen Sender gemäß Patentanspruch 1 gelöst.

Der erfindungsgemäße Sender zum Erzeugen eines hochfrequenten Signals weist einen Quadraturmodulator, einen ersten Oszillator, mindestens einen Frequenzteiler, einen Vergleicher, ein erstes Filter und einen zweiten Oszillator auf. Der Ausgang des ersten Oszillators ist mit dem ersten Eingang des Vergleichers verbunden. Der Ausgang des Quadraturmodulators ist mit dem zweiten Eingang des Vergleichers und der Ausgang des Vergleichers mit dem Eingang des ersten Filters und der Ausgang des ersten Filters mit dem Eingang des zweiten Oszillators verbunden. Der erste Eingang des Quadraturmodulators ist mit dem Ausgang des zweiten Oszillators, an dem auch das hochfrequente Sendesignal anliegt, verbunden. Am zweiten und dritten Eingang des Quadraturmodulators liegen Basisband-Eingangssignale an. Zwischen den ersten Oszillator und den Vergleicher und/oder zwischen den Quadraturmodulator und den Vergleicher ist der Frequenzteiler geschaltet.

Wobei ein Phasenschieber vorgesehen ist, der zwischen den Ausgang des zweiten Oszillators und den ersten Eingang des Quadraturmodulators geschaltet ist, um aus dem hochfrequenten Sendesignal ein Inphasesignal und ein Quadratursignal zu erzeugen, und bei dem der Phasenschieber einen Frequenzteiler aufweist, wobei die Phasenschiebung mittels des Frequenzteilers erzeugt wird.

Vorteilhafterweise wird für die erfindungsgemäße Schaltung weniger Chipfläche benötigt. Ein weiterer Vorteil besteht darin, daß durch die starre Frequenzkopplung, unabhängig von der Kanalfrequenz, eine eventuell auftretende Störung immer exakt mit der Sendefrequenz zusammenfällt, was dann unproblematisch ist.

Vorteilhafte Weiterbildungen ergeben sich aus den abhängigen Ansprüchen.

Weiterhin kann eine Ladungspumpe vorgesehen sein, die dem ersten Filter vorgeschaltet ist.

Der Vergleicher kann auch zum Frequenzvergleich dienen.

Es kann ein Bandpaß vorgesehen sein, das zwischen den Quadraturmodulator und den Vergleicher geschaltet ist.

Der Sender ist für ein Mobilfunksystem verwendbar.

Die Erfindung wird im folgenden anhand von vier Figuren weiter erläutert.

Figur 1     zeigt einen Sender wie er aus dem Stand der Technik bekannt ist.

Figur 2     zeigt das Blockschaltbild eines erfindungsgemäßen Senders.

Figur 3     zeigt die Frequenzlagen im oberen und unteren Seitenband beim Sender gemäß Figur 1.

Figur 4     zeigt die Frequenzlagen im oberen und unteren Seitenband beim erfindungsgemäßen Sender gemäß Figur 2.

Auf Figur 1 wurde bereits oben eingegangen.

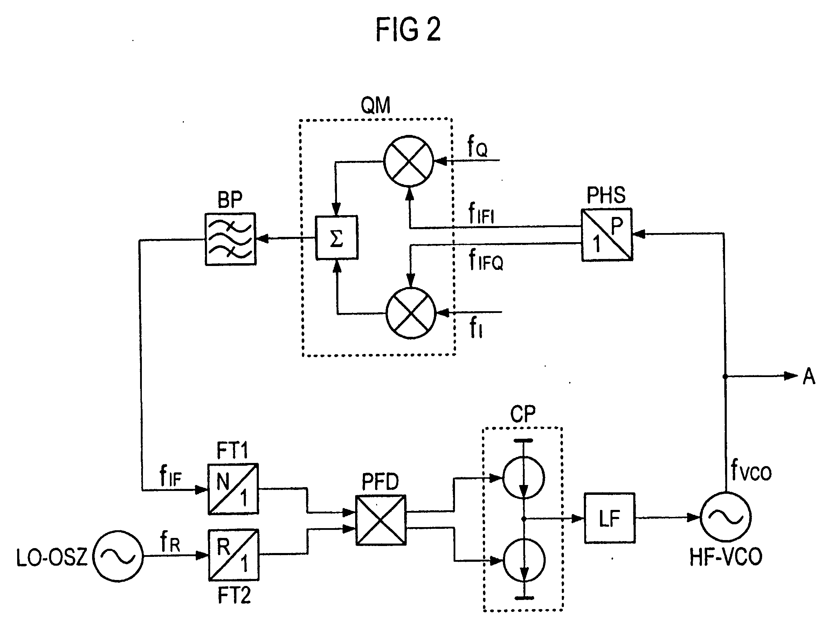

Gegenüber dem in Figur 1 gezeigten Blockschaltbild wurde bei dem in Figur 2 gezeigten Sender erstens der Zwischenfrequenzoszillator ZF-OSZ, der , mit konstanter, fester Frequenz arbeitet, entfernt und zweitens der Mischer M1 und der Tiefpaß TP entfernt und drittens ein lokaler Oszillator LOOSZ, der zur Kanalabstimmung dient, mit dem Eingang des zweiten Frequenzteilers FT2 verbunden.

Der Begriff "verbunden" bedeutet im gesamten Kontext, daß die einzelnen Schaltungselemente entweder direkt oder unter Zwischenschaltung eines oder mehrerer weiterer Schaltungselemente mit dem zweiten Schaltungselement verknüpft sind. Der Begriff "verbunden" soll sowohl eine funktionelle als auch eine physikalische Verbindung zwischen den einzelnen Schaltungselementen umfassen.

In Figur 2 ist zwischen dem Hochfrequenzoszillator HF-VCO und dem ersten Eingang des Quadraturmodulators QM ein Phasenschieber PHS geschaltet, der aus dem Sendesignal, das vom Hochfrequenzoszillator HF-VCO stammt, ein Inphasesignal mit der Frequenz $f_{IFI}$ und ein Quadratursignal mit der Frequenz $f_{IFQ}$ erzeugt. Der Phasenschieber PHS kann beispielsweise einen Frequenzteiler mit dem Teilerwert P (beispielsweise Teilerwert P = 4) aufweisen. Durch den derart realisierten Phasenschieber ist eine einfache und genaue Aufteilung des Sendesignals in das Inphase- und Quadratursignal möglich.

Der erfindungsgemäße Sender für Zellularsysteme erreicht mit geringem Schaltungsaufwand und bei geringem Stromverbrauch ein geringes Breitband-Ausgangsrauschen, erzeugt wenigere unerwünschte Ausgangssignalanteile (z. B. durch unerwünschte Mischprodukte) und die Ausgangsphase folgt genauer dem gewünschten Modulationsschema als der Sender gemäß dem Stand der Technik (Figur 1).

Da bei den Schaltungen gemäß Figur 1 und 2 der Quadraturmodulator QM in die Regelschleife eingesetzt ist, zwingt die PLL (Phase-Locked-Loop) den Hochfrequenzoszillator HF-VCO, der eine hohe Ausgangsleistung liefert, die digitale Modulation aus dem Quadraturmodulator QM so zu verfolgen, daß die Modulation am Eingang des ersten Frequenzteilers FT1 mit dem Teilerwert N aufgehoben wird. Erfüllt die Frequenz fZF gemäß Figur 1 bzw. die Frequenz $f_R$ gemäß Figur 2 die Bedingung $f_{ZF} = f_{IF}$ x R/N bzw. $f_R = f_{IF}$ x R/N, wobei R der Teilerwert des zweiten Teilers FT2 ist, so bleiben Phasen- und Frequenzlagen zwischen den beiden Eingängen des Phasenfrequenzdetektors PFD gleich, nachdem die Phase-Locked-Loop eingerastet ist (Locked-in).

Bisher wurden bei der Schaltungsanordnung gemäß Figur 1 der Quadraturmodulator QM, die Frequenzteiler FT1 und FT2, der Phasenfrequenzdetektor PFD, die Ladungspumpe CP und der Mischer M1 auf einem integrierten Schaltkreis realisiert. Das Tiefpaßfilter TP, das Bandpaßfilter BP, das passive Schleifenfilter LF und der Hochfrequenzoszillator HF-VCO sind bisher externe Komponenten.

Nachteilhaft an der Schaltung gemäß Figur 1 ist die 90°-Phasenschiebung in Quadraturmodulator, da diese durch eine aufwendige Schaltung realisiert werden muß. Eine Korrektur von Phasenfehlern mit Hardware oder Software ist zusätzlich erforderlich.

Vorteilhafter Weise ist bei der Schaltung gemäß Figur 2 das breitbandige Ausgangsrauschen durch die Phase-Locked-Loop stark unterdrückt. Dadurch ist das Bandpaßfilter PB, das dem Quadraturmodulator QM nachgeschaltet ist auch mit geringem Schaltungsaufwand realisierbar.

Beim Kanalwechsel des Hochfrequenzträgersignals mit der Trägerfrequenz $f_{RF}$ wird das Signal mit der Frequenz $f_R$, das vom lokalen Oszillator LOOSZ stammt, mit einem Skalierungsfaktor von R/(N x P) eingestellt.

Beispiel:

Trägerfrequenz $f_{RF}$ = 900 MHz beim GSM-Sender
Kanalraster des Sendesignals = 200 kHz
Teilerwerte N = 2, R = 4, P = 4
Damit ergibt sich der Skalierungsfaktor zu R/(N x P) = 0,5.
Damit ergeben sich folgende Frequenzen:
$f_{IF}$ = 225 MHz, $f_R$ = 450 MHz und 100 kH-Frequenzschritt beim Kanalwechsel.

Mit einem Teilungsfaktor von P = 2 oder P = 4 kann die Phasenverschiebung von 90° durch den Phasenschieber PHS erzeugt werden. Damit entfällt der Phasenschieber im Quadraturmodulator QM. Insbesondere durch eine Einstellung vom Teilerfaktor auf den Wert P = 4 ist ein sehr geringer Phasenfehler zu erwarten, da die Phasenschiebung vom Duty-Cycle des Eingangssignals am Phasenschieber PHS unabhängig ist. Wird ein Teilerwert P > 1 eingestellt, so ist ein entsprechender Skalierungsfaktor für die Inphase- und Quadratursignale im Basisband-Signal-Prozessor (BSP) erforderlich. Dies ist mit geringem schaltungstechnischem Aufwand realisierbar.

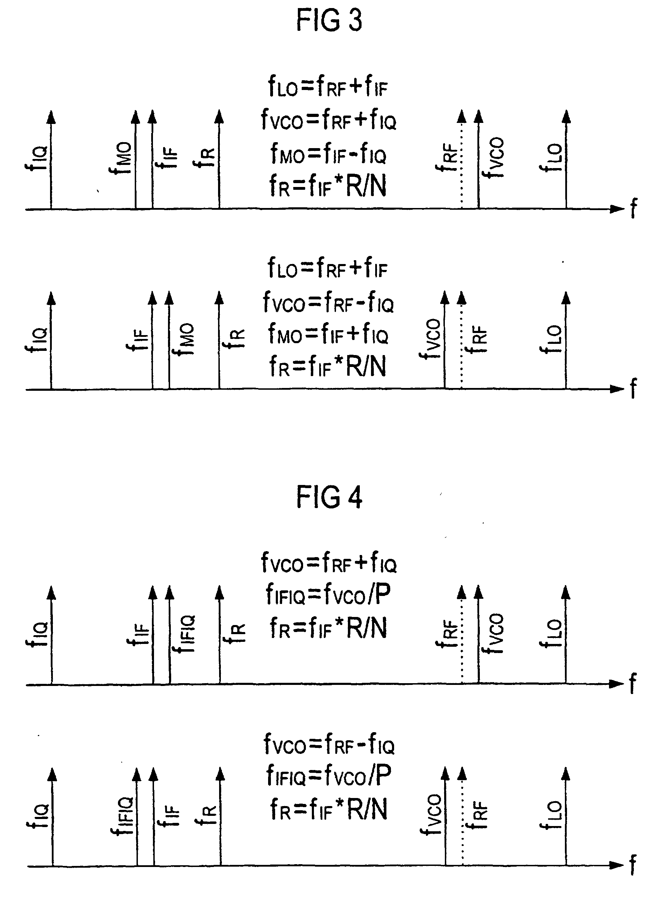

Die Frequenzlagen des Senders gemäß Figur 1 sind in Figur 3 gezeigt. Auf den Abszissen der beiden Diagramme ist jeweils die Frequenz f und auf den Ordinaten die Amplitude angetragen. Im oberen Diagramm der Figur 3 ist das obere Seitenband, im unteren Diagramm der Figur 3 das untere Seitenband gezeigt. Die Frequenz $f_{VCO}$ des Sendesignals im oberen Seitenband ergibt sich aus

$$f_{VCO} = f_{RF} + f_{IQ}$$

Im unteren Seitenband gilt:

$$f_{VCO} = f_{RF} - f_{IQ}$$

wobei

$f_{RF}$ = Trägerfrequenz des Trägersignals
$f_{IQ}$ = Frequenz des Basisbandeingangssignals

Die Frequenz $f_{LO}$ des vom lokalen Oszillator LO stammenden Signals ergibt sich im oberen und unteren Seitenband zu:

$$f_{LO} = f_{RF} + f_{IF}$$

wobei
fIF = Frequenz des vom Quadraturmodulator QM stammenden Signals.

Im oberen Seitenband ergibt sich die Frequenz $f_{Mo}$ zu:

$$f_{Mo} = f_{IF} - f_{IQ}$$

Im unteren Seitenband ergibt sich die Frequenz $f_{Mo}$ zu:

$$f_{Mo} = f_{IF} + f_{IQ}.$$

wobei die Frequenz $f_{Mo}$ die Frequenz des bandpaßgefilterten Ausgangssignals des Mischers M1 ist. Die Frequenz $f_R$ bestimmt sich im oberen und unteren Seitenband zu:

$$f_R = f_{IF} \times R/N$$

Insgesamt treten im oberen Seitenband jeweils in zunehmender Reihenfolge die Frequenzen $f_{IQ}$, $f_{MO}$, $f_{IF}$, $f_R$, $f_{RF}$, $f_{VCO}$ und $f_{LO}$ auf. Im unteren Seitenband treten die Frequenz in aufsteigender Reihenfolge wie folgt auf: $f_{IQ}$, $f_{IF}$, $f_{MO}$, $f_R$, $f_{VCO}$, $f_{RF}$ und $f_{LO}$.

Bei dem in Figur 4 oben gezeigten oberen Seitenband treten die Frequenzen in folgender aufsteigender Reihenfolge auf: $f_{IQ}$, $f_{IF}$, $f_{IFIQ}$, $f_R$, $f_{RF}$ und $f_{VCO}$.

Bei dem in Figur 4 unten gezeigten unteren Seitenband treten die Frequenzen in folgender aufsteigender Reihenfolge auf: $f_{IQ}$, $f_{IFIQ}$, $f_{IF}$, $f_R$, $f_{VCO}$ und $f_{RF}$.

Im oberen Seitenband ergibt sich die Frequenz $f_{VCO}$ zu:

$$f_{VCO} = f_{RF} + f_{IQ}$$

Die Frequenz $f_{IFIQ}$ der am Ausgang des Phasenschiebers PHS anliegenden Inphase bzw. Quadratursignale ergibt sich in beiden Seitenbändern zu:

$$f_{IFIQ} = f_{VCO}/P$$

Die Frequenz $f_R$ ergibt sich in beiden Seitenbändern zu:

$$f_R = f_{IF} \times R/N.$$

Im unteren Seitenband ergibt sich die Frequenz $f_{VCO}$ des Sendesignals zu:

$$f_{VCO} = f_{RF} - f_{IQ}.$$

Die in Figur 1 gezeigte Schaltungsanordnung hat den Nachteil, daß ein Zwischenfrequenzoszillator ZF-OSZ mit einem Frequenzsynthesizer für die Erzeugung des Zwischenfrequenzoszillatorausgangssignals mit der Frequenz $f_{ZF}$ und ein lokaler Oszillator LO mit einem Frequenzsynthesizer für die Erzeugung des Signals mit der Frequenz $f_{LO}$ für die Kanaleinstellung notwendig sind.

Bei der in Figur 2 gezeigten erfindungsgemäßen Schaltungsanordnung fällt vor allem gegenüber dem Sender gemäß dem Stand der Technik in Figur 1 der Schleifenfilter M1, das entsprechende Tiefpaßfilter TP und der Zwischenfrequenzoszillator ZF-OSZ mit dem Frequenzsynthesizer für die Erzeugung des Signals mit der Frequenz $f_{ZF}$ weg.

Der neue Sender hat somit unter anderem folgende Vorteile. Prinzipbedingt treten keine unerwünschten Mischprodukte mehr auf, der Schaltungsaufwand wird reduziert und die Stromaufnahme durch den Wegfall des Zwischenfrequenzoszillators ZF-OSZ, der das Signal mit der Frequenz $f_{ZF}$ erzeugt, reduziert. Ebenso wird die Stromaufnahme durch Wegfall des Schleifenmischers M1 und des entsprechenden Tiefpaßfilters TP verringert.

Der Hochfrequenzoszillator HF-VCO ist ein spannungsgesteuerter Oszillator. Der lokale Oszillator LOOSZ kann ebenfalls ein spannungsgesteuerter Oszillator sein.

## Patentansprüche

**1.** Sender zum Erzeugen eines hochfrequenten Sendesignals,

- bei dem ein Quadraturmodulator (QM), ein erster Oszillator (LOOSZ), mindestens ein Frequenzteiler (FT1, FT2), ein Vergleicher (PFD), ein erstes Filter (LF) und ein zweiter Oszillator (HF-VCO) vorgesehen sind,
- bei dem der Ausgang des ersten Oszillators (LOOSZ) mit dem ersten Eingang des Vergleichers (PFD) verbunden ist,
- bei dem der Ausgang des Quadraturmodulators (QM) mit dem zweiten Eingang des Vergleichers (PFD) verbunden ist,
- bei dem der Ausgang des Vergleichers (PFD) mit dem Eingang des ersten Filters (LF) verbunden ist,
- bei dem der Ausgang des ersten Filters (LF) mit dem Eingang des zweiten Oszillators (HF-VCO) verbunden ist,
- bei dem der erste Eingang des Quadraturmodulators (QM) mit dem Ausgang des zweiten Oszillators (HF-VCO), an dem auch das hochfrequente Sendesignal anliegt, verbunden ist,
- bei dem am zweiten und dritten Eingang des Quadraturmodulators (QM) Basisband-Eingangssignale anliegen,
- bei dem zwischen den ersten Oszillator (LOOSZ) und den Vergleicher (PFD) oder/und zwischen den Quadraturmodulator (QM) und den Vergleicher (PDF) der Frequenzteiler (FT1, FT2) geschaltet ist,
- bei dem ein Phasenschieber (PHS) vorgesehen ist, der zwischen den Ausgang des zweiten Oszillators (HF-VCO) und den ersten Eingang des Quadraturmodulators (QM) geschaltet ist, um aus dem hochfrequenten Sendesignal ein Inphasesignal und ein Quadratursignal zu erzeugen, und
- bei dem der Phasenschieber (PHS) einen Frequenzteiler aufweist, wobei die Phasenschiebung des Phasenschiebers mittels des Frequenzteilers erzeugt wird.

2. Sender nach dem Anspruch 1,
bei dem eine Ladungspumpe (CP) vorgesehen ist,
die dem ersten Filter (LF) vorgeschaltet ist.

3. Sender nach Anspruch 1 oder 2,
bei dem der Vergleicher (PFD) auch zum Frequenzvergleich dient.

4. Sender nach einem der Ansprüche 1 bis 3,
bei dem ein Bandpaß (BP) vorgesehen ist, der zwischen den Quadraturmodulator (QM) und den Vergleicher (PFD) geschaltet ist.

5. Verwendung des Senders nach einem der Ansprüche 1 bis 4, für ein Mobilfunksystem.

**Claims**

1. Transmitter for production of a radio-frequency transmission signal,

   - in which a quadrature modulator (QM), a first oscillator (LOOSC), at least one frequency divider (FT1, FT2), a comparator (PFD), a first filter (LF) and a second oscillator (RF-VCO) are provided,
   - in which the output of the first oscillator (LOOSC) is connected to the first input of the comparator (PFD),
   - in which the output of the quadrature modulator (QM) is connected to the second input of the comparator (PFD),
   - in which the output of the comparator (PFD) is connected to the input of the first filter (LF),
   - in which the output of the first filter (LF) is connected to the input of the second oscillator (RF-VCO),
   - in which the first input of the quadrature modulator (QM) is connected to the output of the second oscillator (RF-VCO), at which the radio-frequency transmission signal is also produced,
   - in which baseband input signals are applied to the second and third inputs of the quadrature modulator (QM),
   - in which the frequency divider (FT1, FT2) is connected between the first oscillator (LOOSC) and the comparator (PFD) and/or between the quadrature modulator (QM) and the comparator (PDF),
   - in which a phase shifter (PHS) is provided, which is connected between the output of the second oscillator (RF-VCO) and the first input of the quadrature modulator (QM), in order to produce an in-phase signal and a quadrature signal from the radio-frequency transmission signal, and
   - in which the phase shifter (PHS) has a frequency divider, with the phase shift of the phase shifter being produced by means of the frequency divider.

2. Transmitter according to Claim 1,
in which a charge pump (CP) is provided, and is connected upstream of the first filter (LF).

3. Transmitter according to Claim 1 or 2,
in which the comparator (PFD) is also used for frequency comparison.

4. Transmitter according to one of Claims 1 to 3,
in which a bandpass filter (BP) is provided, and is connected between the quadrature modulator (QM) and the comparator (PFD).

5. Use of the transmitter according to one of Claims 1 to 4 for a mobile radio system.

**Revendications**

1. Émetteur de production d'un signal d'émission de haute fréquence,

   - dans lequel Il est prévu un modulateur(QM) à quadrature, un premier oscillateur (LOOSZ), au moins un diviseur (FT1, FT2) de fréquence, un comparateur (PFD), un premier filtre (LF) et un deuxième oscillateur (HF-VCO),
   - dans lequel la sortie du premier oscillateur (LOOSZ) est reliée à la première entrée du comparateur (PFD),
   - dans lequel la sortie du modulateur (QM) à quadrature est reliée à la deuxième entrée du comparateur (PFD),
   - dans lequel la sortie du comparateur (PFD) est reliée à l'entrée du premier filtre (LF),
   - dans lequel la sortie du premier filtre (LF) est reliée à l'entrée du deuxième oscillateur (HF-VCO),
   - dans lequel la première entrée du modulateur (QM) à quadrature est reliée à la sortie du deuxième oscillateur (HF-VCO), à laquelle est appliqué aussi le signal d'émission de haute fréquence,
   - dans lequel il est appliqué à la deuxième et à la troisième entrées du modulateur (QM) à quadrature des signaux d'entrée de bande de base,
   - dans lequel il est monté entre le premier oscillateur (LOOSZ) et le comparateur (PFD) oulet entre le modulateur (QM) à quadrature et le comparateur (PDF) le diviseur (FT1, FT2) de fréquence,

- dans lequel il est prévu un déphaseur (PHS) qui est monté entre la sortie du deuxième oscillateur (HF-VCO) et la première entrée du modulateur (QM) à quadrature pour produire à partir du signal d'émission de haute fréquence un signal en phase et un signal en quadrature, et
- dans lequel le déphaseur (PHS) a un diviseur de fréquence, le déphasage du déphaseur étant produit au moyen du diviseur de fréquence.

2. Émetteur suivant la revendication 1, dans lequel il est prévu une pompe (CP) de charge, qui est montée on amont du premier filtre (LF).

3. Émetteur suivant la revendication 1 ou 2, dans lequel le comparateur (PFD) sert aussi à comparer les fréquences.

4. Émetteur suivant l'une des revendications 1 à 3, dans lequel il est prévu un filtre (BP) de bande passante, qui est monté entre le modulateur (QM) à quadrature et le comparateur (PFD).

5. Utilisation de l'émetteur suivant l'une des revendications 1 à 4 pour un système de téléphonie mobile.

FIG 1

EP 0 905 884 B1

# FIG 2

EP 0 905 884 B1

# FIG 3

$$f_{LO}=f_{RF}+f_{IF}$$
$$f_{VCO}=f_{RF}+f_{IQ}$$
$$f_{MO}=f_{IF}-f_{IQ}$$
$$f_R=f_{IF}*R/N$$

$f_{IQ}$  $f_{MO}$  $f_{IF}$  $f_R$  $f_{RF}$  $f_{VCO}$  $f_{LO}$  f

$$f_{LO}=f_{RF}+f_{IF}$$
$$f_{VCO}=f_{RF}-f_{IQ}$$
$$f_{MO}=f_{IF}+f_{IQ}$$
$$f_R=f_{IF}*R/N$$

$f_{IQ}$  $f_{IF}$  $f_{MO}$  $f_R$  $f_{VCO}$  $f_{RF}$  $f_{LO}$  f

# FIG 4

$$f_{VCO}=f_{RF}+f_{IQ}$$
$$f_{IFIQ}=f_{VCO}/P$$
$$f_R=f_{IF}*R/N$$

$f_{IQ}$  $f_{IF}$  $f_{IFIQ}$  $f_R$  $f_{RF}$  $f_{VCO}$  $f_{LO}$  f

$$f_{VCO}=f_{RF}-f_{IQ}$$
$$f_{IFIQ}=f_{VCO}/P$$
$$f_R=f_{IF}*R/N$$

$f_{IQ}$  $f_{IFIQ}$  $f_{IF}$  $f_R$  $f_{VCO}$  $f_{RF}$  $f_{LO}$  f